**Europäisches Patentamt**

**European Patent Office**

**Office européen des brevets**

(19)

(11) Veröffentlichungsnummer: **0 200 089**
**B1**

(12) **EUROPÄISCHE PATENTSCHRIFT**

(45) Veröffentlichungstag der Patentschrift:
**12.07.89**

(51) Int. Cl.⁴: **H01G 13/06**, B23K 26/00

(21) Anmeldenummer: **86105204.1**

(22) Anmeldetag: **15.04.86**

(54) **Verfahren zur Bildung von schmalen, metallfreien Streifen in der Metallschicht von Kunststoffolien.**

(30) Priorität: **24.04.85 DE 3514824**

(43) Veröffentlichungstag der Anmeldung:
**10.12.86 Patentblatt 86/45**

(45) Bekanntmachung des Hinweises auf die Patenterteilung:
**12.07.89 Patentblatt 89/28**

(84) Benannte Vertragsstaaten:
**DE FR GB IT SE**

(56) Entgegenhaltungen:
**EP-A- 0 131 504**
**FR-A- 2 103 198**
**US-A- 4 322 601**

**24TH ELECTRONIC COMPONENTS
CONFERENCE, 13.-15. Mai 1974, Washington, US,
Seiten 240-244; G. HURTIG et al.: "An overview of laser
functional trimming techniques"**

(73) Patentinhaber: **Siemens Aktiengesellschaft Berlin und
München, Wittelsbacherplatz 2, D-8000 München 2(DE)**

(72) Erfinder: **Behn, Reinhard, Dipl.-Phys.,
Frasdorferstrasse 6 d, D-8000 München 90(DE)**

## Beschreibung

Die Erfindung betrifft ein Verfahren zur Bildung von metallfreien Streifen auf einer Kunststoffolie, die mit einer dünnen, insbesondere regenerierfähig dünnen Schicht eines verdampfbaren Metalls, insbesondere Aluminium, versehen ist und zur Herstellung von elektrischen Kondensatoren dient, bei dem die Metallschicht an den zu entmetallisierenden Bereichen durch intensive, gepulste Laserstrahlen von der Oberfläche der relativ zu den Laserstrahlen bewegten Kunststoffolie entfernt wird.

Ein solches Verfahren ist aus der US-PS 4 462 062 bekannt, bei dem eine breite Kunststoffolie mit vollständig metallisierter Oberfläche unter einer Laserabbrennstation hindurch bewegt wird, an der mehrere parallel zueinander in einer Ebene angeordnete Laserstrahlen zum Abbrennen der Metallschicht und zur Bildung äußerst schmaler entmetallisierter Streifen benutzt werden. Die Auftreffpunkte der Laserstrahlen auf der Folienoberfläche liegen auf einer Linie senkrecht zur Richtung des Bandvorschubes, so daß jeder Laserstrahl zur Bildung eines metallfreien Streifens verwendet wird.

Zur Herstellung von Kondensatoren werden mit metallfreien Streifen versehene, breite, meist gereckte Kunststoffolien aus Polyäthylenterephthalat, Polycarbonat, Polypropylen oder einem anderen geeigneten Dielektrikum, in schmale Bänder zerschnitten, die an einer Kante über einen entmetallisierten Freirand verfügen und zu Rund- oder Flachwickeln verarbeitet oder nach einem bekannten Verfahren geschichtet werden.

Diese Kondensatorwickel bzw. -stapel werden im Metallspritzverfahren an ihren Stirnseiten kontaktiert, wobei alle Metallisierungen, die sich bis zum Rand der Stirnseiten erstrecken, elektrisch leitend miteinander verbunden werden.

Besitzen die schmalen Kunststoffbänder anstelle eines vollständig entmetallisierten Freirandes im Bereich einer Kante einen dünnen, metallfreien Streifen, der den Randbereich der Metallisierung vom kapazitiv wirksamen Bereich der Metallisierung isoliert, ergeben sich besonders gleichmäßige Wickel und Stapel, bei denen an jeder Stirnseite die doppelte Anzahl von metallisierten Schichten zur Kontaktierung zur Verfügung steht, was die Haftfähigkeit der aufgespritzten Metallschicht merklich erhöht. Für Kondensatoren mit einer Nennspannung von 63 V sind Isolierstreifen mit einer Breite von lediglich 0,1 mm bereits ausreichend.

Zur Bildung von Freirändern oder Isolierstreifen auf dünnen, metallbeschichteten Kunststoffolien sind verschiedene Verfahren bekannt.

Häufig angewendete, das nur wenige µm starke Folienmaterial weitgehend schonende Methoden, sehen die Verwendung von Blenden, mitlaufenden Abdeckbändern oder wieder entfernbaren Schutzschichten auf Ölbasis vor, die bereits während der Metallisierung der Folie durch Bedampfen in Vakuum bestimmte, insbesondere streifenförmige, Bereiche der Folienoberfläche von einer Metallschicht freihalten.

Ein derartiges Verfahren ist beispielsweise in der DE-OS 3 224 234 beschrieben.

Ein Nachteil dieser aufwendigen Verfahren liegt darin, daß die gebildeten metallfreien Streifen nicht beliebig schmal gemacht werden können; die untere Grenze liegt bei etwa 1 mm.

Nachteilig ist auch, daß in den Randbereichen der gebildeten Streifen oft Reste von Abdecköl verbleiben, die in den Kondensatorwickel eingearbeitet werden und auf lange Sicht zu einer Veränderung der Kondensatoreigenschaften führen können.

Schließlich können breite Kunststoffolien, die bereits bei der Metallisierung mit metallfreien Streifen versehen werden, ausschließlich für einen von vorne herein festgelegten Verwendungszweck eingesetzt werden.

Daneben sind Verfahren bekannt, breite und vollständig metallisierte Kunststoffolien nachträglich mit metallfreien Streifen zu versehen.

Dazu eignen sich beispielsweise kreisrunde Ausbrennscheiben mit einer der Breite der auszubrennenden Streifen entsprechenden Stärke, die als Ausbrennelektroden federnd gegen die Metallisierung einer freitragend geführten, metallisierten Isolierstoffolie gedrückt werden und eine örtlich begrenzte Zerstörung der Metallisierung mittels eines elektrischen Stromes bewirken, wobei die Metallisierung die notwendige Gegenelektrode darstellt. Ein solches Verfahren ist in der DE-OS 2 348 904 beschrieben.

Das Verfahren des Abbrennens unerwünschter Metallschichten mittels spannungsführender Elektroden ist insbesondere bei dünnen Kunststoffolien jedoch nicht problemlos anwendbar, da die sehr dünnen Folien an den abgebrannten Stellen infolge ihrer thermoplastischen Eigenschaften durch die Funkenbildung leicht verformt oder beschädigt werden können.

Daneben gibt es rein mechanisch wirkende Verfahren, bei denen die Metallschicht der Kunststoffolie durch rotierende Schleifscheiben abgeschliffen wird.

In der DE-AS 2 509 543 werden hierzu Schleifscheiben verwendet, die aus gebundenen, harten, scharfkantigen Körnern von verschiedenen Feinheitsgraden gebildet sind. Die Kunststoffolie wird dabei durch Regelung ihrer Bandspannung mit einem definierten Andruck an die Schleifscheiben gedrückt.

Auch Schleifscheiben, z. B. aus Gummi oder Silikongummi, eignen sich für den genannten Zweck, wie die DE-AS 1 938 320 zeigt, nach der die Scheiben zum Entfernen von Metallschichtbereichen Schleifscheiben sind, die in Betrieb hohe Drehzahlen aufweisen und die über das dazwischengeführte Isolierstoffband auf eine Gegenrolle drückend angeordnet sind.

Das Abreiben oder Abradieren der Metallisierung durch schnell rotierende Schleifscheiben aus Gummi oder Silikongummi hat sich in der Praxis, wenn auch mit einigem Aufwand, als gut durchführbar erwiesen, birgt aber durch den notwendigen Druck auf die genannte Gegenrolle die Gefahr der Überdehnung und somit der Beschädigung insbesondere dünner Kunststoffolien an den zu entmetallisierenden Bereichen.

Auch beim vorher genannten Verfahren, bei dem auf eine Andruckrolle verzichtet werden kann, ist die Gefahr des Durchschleifens der Folie durch die aus harten, scharfkantigen Körnern bestehende Schleifscheibe gegeben.

Schließlich ist die erzielbare Breite der Streifen durch die Stärke der Ausbrenn- bzw. Schleifscheiben begrenzt. Die bereits genannte DE-AS 1 938 320 spricht von metallfreien Streifen, die mit einer Breite von 0,3 mm hergestellt werden können.

Ein äußerst flexibles, die Folie relativ schonendes, da berührungslos wirkendes Verfahren zur Bildung von metallfreien Streifen auf metallisierten Kunststoffolien stellt das Abbrennen der Metallbeschichtung durch intensive Laserimpulse dar. Dieses Verfahren, das in der bereits genannten US-PS 4 462 062 beschrieben ist, vermeidet die bekannten Nachteile der genannten Verfahren und hat darüber hinaus den Vorteil, daß auch sehr viel schmalere Streifen erzeugt werden können.

Ein Problem bei der Anwendung von Laserstrahlen zur Entmetallisierung von dünnen Kunststoffolien liegt in der allgemein sehr hohen Laserintensität. Ein kontinuierlicher oder ein in rascher Folge auf denselben Folienbereich auftreffender gepulster Laserstrahl würde nicht nur die Metallschicht verdampfen, sondern auch das thermoplastische Material der Kunststoffolie unerwünscht stark erhitzen oder sogar zerstören.

Dabei ist nicht erst ein Schmelzen oder Verdampfen des Folienmaterials von Nachteil. Die gereckten Kunststoffolien haben bereits bei deutlich niedrigeren Temperaturen als dem Schmelzpunkt des Kunststoffes die Eigenschaft, sich zu entrecken, wodurch beispielsweise Falten und Wellen im Folienmaterial auftreten, das dadurch für die Herstellung einwandfreier Wickel und Stapel unbrauchbar wird. Aus diesem Grund werden insbesondere temperaturstabile Kunststoffolien mit diesem Verfahren bearbeitet.

Es kann daher meist nur ein extrem kurzer, intensiver Laserimpuls angewendet werden, um die bei regenerierfähig dünnen Metallschichten mit Flächenleitfähigkeiten unter 1 Siemens nur etwa 0,02 µm bis 0,05 µm starke Metallisierung, die beispielsweise aus Aluminium besteht, am Auftreffpunkt des Laserstrahls zu verdampfen und eine metallfreie Fläche in der Metallisierung der Folie zu erzeugen, deren Form und Größe im wesentlichen der Form und der Größe des Lichtfleckes des Laserstrahles auf der Folienoberfläche entspricht.

Die Aneinanderreihung von sich teilweise überlappenden entmetallisierten Flächen ergibt schließlich, wenn alle Vorsichtsmaßnahmen beachtet werden, einen zusammenhängenden, metallfreien Streifen in der Metallisierung der Folie, der typische wellenförmige Berandung aufweist.

Der vorliegenden Erfindung liegt die Aufgabe zugrunde, ein Verfahren der eingangs genannten Art anzugeben, bei dem die Vorschubgeschwindigkeit v, mit der eine mit metallfreien Streifen zu versehende metallisierte Kunststoffolie relativ zu den gepulsten Laserstrahlen einer Laserabbrennstation bewegt wird, gegenüber bisherigen Verfahren bei gleicher Taktfrequenz f der Laserimpulse um ein Vielfaches erhöht wird und gleichzeitig die thermische Belastung des Folienmaterials weitgehend reduziert wird, so daß insbesondere sehr dünne Folien und solche aus einem weniger temperaturstabilen Kunststoff mit wirtschaftlichen Entmetallisierungsgeschwindigkeiten bearbeitet werden können.

Die Lösung dieser Aufgabe ist erfindungsgemäß gekennzeichnet durch die Verfahrensschritte

a) die metallisierte Kunststoffolie wird mit einer Vorschubgeschwindigkeit v relativ zu einer Anzahl n > 1 mit der Taktfrequenz f gepulster Laserstrahlen bewegt, die die Metallschicht der Kunststoffolie in dem Bereich eines zu entmetallisierenden Streifens beaufschlagen und die parallel zueinander in einer Ebene angeordnet sind, zu der die Richtung der Translationsbewegung der Folie parallel verläuft,

b) durch Dauer und Intensität der einzelnen Impulse der Laserstrahlen wird bei jedem Impuls nur eine Fläche der Metallschicht verdampft,

c) der aus Vorschubgeschwindigkeit v der Folie und Taktfrequenz f der Laserimpulse resultierende Taktabstand der Zentren zweier nacheinander von demselben Laserstrahl entmetallisierter Flächen beträgt mindestens ein der Anzahl n der verwendeten Laserstrahlen entsprechendes Vielfaches der halben Länge dieser Flächen, höchstens aber das n-fache der um die Hälfte der Flächenbreite verkürzten Länge der entmetallisierten Flächen.

d) Der Abstand der Zentren der Bereiche, in denen zwei benachbarte Laserstrahlen auf die Folienoberfläche auftreffen, nämlich die Abkühlstrecke, ist jeweils um den n-ten Teil des Taktabstandes größer als ein ganzzahliges Vielfaches des Taktabstandes der Zentren zweier benachbarter, von demselben Laserstrahl entmetallisierter Flächen.

Das bekannte Verfahren bereitet in der Praxis Schwierigkeiten, weil es unberücksichtigt läßt, daß sich an jeden Laserimpuls eine Abkühlphase anschließen muß, in der das nur wenige µm starke Foliensubstrat in der Umgebung der bereits entmetallisierten Fläche so weit abkühlen kann, daß der folgende Laserimpuls, der wegen der Vorschubbewegung der Folie mit der Geschwindigkeit v relativ zu den Laserstrahlen um eine bestimmte Strecke, beispielsweise die halbe Länge der entmetallisierten Fläche versetzt auf die Folie auftrifft, nicht zu einer unerwünschten Verformung oder Zerstörung der thermoplastischen Folie führt (Entreckung).

Die halbe Länge der entmetallisierten Fläche bedeutet im Falle einer kreisförmigen Fläche deren Radius, bei elliptischen Flächen die große Halbachse der Ellipse.

Die Dauer dieser Abkühlphase wird durch den Grad der Aufheizung der Folie durch die bei jedem Laserimpuls im Bereich des Auftreffpunktes der Laserstrahlen bis über die Verdampfungstemperatur aufgeheizte Metallschicht und den über der Folienoberfläche befindlichen, ebenfalls von den Laserimpulsen angeregten und erhitzten Metalldampf sowie das Maß der Wärmeableitung in dem betreffenden Folienbereich bestimmt.

Bei gegebener Laserimpulsintensität, die durch die Eigenschaften der Metallisierung und der Kunststoffolie festgelegt wird, ist die maximal erzielbare Vorschubgeschwindigkeit v der Folie durch die erforderliche Abkühlzeit und die Versatzstrecke zwischen den Zentren zweier benachbarter, entmetallisierter Flächen festgelegt.

Das Verfahren der Bildung von metallfreien Flächen in metallisierten Kunststoffolien mittels gepulster Laserstrahlen kann nicht nur für extrem dünne Metallschichten mit Flächenleitfähigkeiten unter 1 Siemens eingesetzt werden, sondern durch einfache Veränderung der Dauer der Laserimpulse auch für deutlich dickere Metallschichten mit Flächenleitfähigkeit größer 1 Siemens, was ein Beispiel für die Flexibilität dieser Technik darstellt.

Insbesondere sehr dünne Folien mit einer Dicke von weniger als 2 µm können nach dem bisher bekannten Verfahren nur sehr langsam mittels Laserstrahlen mit metallfreien Streifen versehen werden, da die notwendige Abkühlzeit entsprechend hoch ist.

Für eine Folie von 3 µm Stärke mit einer 30 nm dicken Metallschicht aus Aluminium werden beispielsweise Entmetallisierungsgeschwindigkeiten von höchstens 2,5 m/s bis 3 m/s erreicht, bei denen jedoch schon qualitätsmindernde Verformungen des Folienmaterials auftreten.

Damit liegt die erzielbare Entmetallisierungsgeschwindigkeit deutlich unter den Geschwindigkeiten, mit denen die Metallisierung der Kunststoffbänder erfolgt, wobei Bandgeschwindigkeiten von 6 m/s und mehr erreicht werden.

Eine effektive und vorteilhafte Koppelung dieser beiden Prozesse ist somit bei dem bekannten Verfahren nicht möglich.

Die Erfindung ermöglicht durch ausreichend große Bemessung der Abkühlstrecke bei gegebener Taktfrequenz der Laserimpulse eine wesentlich längere Abkühlphase bis zum Auftreffen des nächsten Laserimpulses auf einen Teil einer bereits entmetallisierten Fläche der Folie, was die Gefahr der Überhitzung besonders dünner Folien in diesem Bereich praktisch ausschließt.

Selbstverständlich läßt sich das Verfahren der Erfindung gleichermaßen vorteilhaft auch bei dickeren Folien von beispielsweise mehr als 10 µm Folienstärke anwenden.

Zusätzlich wird durch die Erfindung erreicht, daß bei gleicher Taktfrequenz f der Laserimpulse die Vorschubgeschwindigkeit v der Folie gegenüber dem bisherigen Verfahren um den Faktor n erhöht wird, wobei n der Anzahl der verwendeten Laserstrahlen entspricht.

Insbesondere ermöglicht die Erfindung die Bearbeitung besonders dünner metallisierter Folien mit Materialstärken von 2 µm und weniger, die bisher nur unwirtschaftlich langsam mit Laserstrahlen entmetallisiert werden konnten, was nicht nur einen technischen, sondern auch einen wirtschaftlichen Erfolg der Erfindung darstellt.

Die Taktfrequenz f der Laserimpulse und die Vorschubgeschwindigkeit v der Folie relativ zu den Laserstrahlen können bei dem Verfahren der Erfindung jedoch weiter erhöht werden, da derselbe Laserstrahl nach der Lehre der Erfindung nicht mehr auf ein bereits entmetallisiertes und damit erhitztes Gebiet der Folie auftrifft, denn eine Überlappung von nacheinander von demselben Laserstrahl metallisierter Flächen ist schon für n = 2 verwendete Laserstrahlen weitestgehend ausgeschlossen.

Wegen des exponentiellen Abklingens der Übertemperatur der Folie in der Umgebung einer entmetallisierten Fläche bewirkt schon eine geringe Vergrößerung des Abstandes der Zentren zweier nacheinander von demselben Laserstrahl entmetallisierter Flächen eine deutliche Verkürzung der noch notwendigen Abkühlphase bis zum Auftreffen des nachfolgenden Laserimpulses dieses Laserstrahles auf der Folienoberfläche, die im wesentlichen durch den verbleibenden Effekt der Aufheizung der Folie durch den über dem Auftreffpunkt des Laserstrahls befindlichen, heißen Metalldampf bestimmt wird.

Dieser Effekt läßt sich aber vorteilhaft dadurch weitgehend unterdrücken, daß durch eine tangentiale Strömung eines inerten Gases, beispielsweise Stickstoff, senkrecht zur Bandvorschubrichtung dieser heiße Metalldampf aus dem Bereich der Laserstrahlung entfernt wird.

Es ist somit nach dem Verfahren der Erfindung möglich, selbst äußerst dünne Kunststoffolien problemlos mit Entmetallisierungsgeschwindigkeiten zu bearbeiten, die den Geschwindigkeiten entsprechen, mit denen die Folien mit einer Metallschicht versehen werden, was eine wirtschaftlich sehr vorteilhafte Koppelung beider Prozesse gestattet.

Da die verfügbare Impulsenergie geeigneter Laser im allgemeinen ein Vielfaches der zum Verdampfen der dünnen Metallisierung erforderlichen Impulsenergie beträgt, ist es von Vorteil, die in einer Ebene parallel zueinander angeordneten n Laserstrahlen unter Verwendung n - 1 teildurchlässiger Spiegel und eines total reflektierenden Spiegels aus einem einzelnen Laserstrahl zu erzeugen und durch die Wahl des Reflexionsvermögens der einzelnen teildurchlässigen Spiegel den ursprünglichen Laserstrahl in n Strahlen annähernd gleicher Energie aufzuteilen. Die Anzahl n der erzeugten Laserstrahlen wird dabei üblicherweise kleiner als 10 bleiben, ist aber prinzipiell nur durch die verfügbare Laserintensität und die zum Verdampfen der Metallschicht nötige Impulsintensität beschränkt.

Für n = 4 Laserstrahlen werden beispielsweise n - 1 = 3 teildurchlässige Spiegel benötigt, die jeweils 25 % der Laserintensität des ursprünglichen Laserstrahles abzweigen. Die erforderlichen Werte für Transmission und Reflexion dieser Spiegel bei der Wellenlänge der verwendeten Laserstrahlung sind für dieses Beispiel in Tabelle 1 angegeben, wobei die Absorption der Spiegel vernachlässigt ist.

Tabelle 1

| n = 4 | Transmission | Reflexion |
|---|---|---|
| Spiegel 1 | 75% | 25% |
| Spiegel 2 | 67% | 33% |
| Spiegel 3 | 50% | 50% |
| Spiegel 4 | – | 100% |

Dieses Vorgehen erübrigt eine Synchronisation der n Laserstrahlen, wie sie bei Verwendung von n separaten gepulsten Lasern unumgänglich ist.

Ferner ist es für das Verfahren von Vorteil, wenn die metallisierte Kunststoffolie zwischen zwei benachbarten Laserstrahlen über wenigstens eine Anordnung von 3 Umlenkrollen geführt wird, von denen die erste und die dritte Umlenkrolle hinsichtlich ihrer Achsen in einer Ebene liegen und die zweite Umlenkrolle zwischen der ersten und dritten Umlenkrolle außerhalb der Ebene ihrer Achsen angeordnet ist, daß die Umlenkrollen aus Metall oder einem anderen gut wärmeleitenden Material bestehen und daß der Abstand der Achse der zweiten Umlenkrolle von der Ebene, in der die Achsen der beiden äußeren Umlenkrollen liegen, zur Einstellung der erforderlichen Abkühlstrecke des Bandes verstellbar ist.

Durch diese vorteilhafte Ausgestaltung wird der Abstand zwischen den einzelnen Laserstrahlen verringert, ohne die Abkühlstrecke zu verkürzen, darüber hinaus können unterschiedliche Abkühlstrecken eingestellt und an die Erfordernisse des genannten Verfahrens angepaßt werden, ohne daß eine Justierung der Laserstrahlen vorgenommen werden muß.

Die Führung der Folie zwischen den Auftreffpunkten benachbarter Laserstrahlen über Umlenkrollen aus Metall oder einem anderen gut wärmeleitenden Material bewirkt schließlich eine vorteilhafte Kühlung der bereits entmetallisierten und somit erhitzten Gebiete der Kunststoffolien vor dem Auftreffen des nächsten Laserimpulses und somit eine Verkürzung der Abkühlstrecke.

Das Verfahren der Erfindung läßt sich besonders vorteilhaft anwenden, wenn die n Laserstrahlen lotrecht auf die Oberfläche der metallisierten Kunststoffolie auftreffen, da dann eine symmetrische Energieverteilung im Bereich des Auftreffpunktes des Laserstrahles auf der Oberfläche der Folie vorliegt, die zu besonders gleichmäßig entmetallisierten Flächen führt.

Eine vorteilhafte Ausführung des Verfahrens der Erfindung sieht vor, daß zur Bildung von metallfreien Flächen in Form von Ellipsen oder Langlöchern, deren Längsausdehnung mit der Richtung der Translationsbewegung der Kunststofffolie übereinstimmt, in den Strahlengang jedes Laserstrahles jeweils eine, den Strahlenquerschnitt der Laserstrahlen beeinflussende Optik eingebracht wird.

Es ist dem Fachmann möglich, durch Einbringen von Linsen und Blenden in den Strahlengang der jeweiligen Laserstrahlen neben kreisrunden Flächen auch solche mit elliptischer oder länglicher Form zu bilden.

Besonders gut eignen sich beispielsweise längliche Flächen mit einer Form, die dem Querschnitt eines Langloches entspricht. Bei jedem einzelnen Laserimpuls wird ein dünner, langer Streifen mit runden Endbereichen entmetallisiert, bei dem es genügt, wenn die Strecke, auf der sich benachbarte entmetallisierte Flächen entlang der Verbindungslinie ihrer Zentren überlappen, nicht größer als die Breite dieser entmetallisierten Flächen ist, um einen entmetallisierten Streifen zu erhalten, dessen Berandung praktisch keine Welligkeit mehr aufweist.

Beim Verfahren nach der Erfindung verwendet man vorzugsweise eine metallisierte Folie, die aus einem für die Strahlung des verwendeten Lasers weitgehend transparenten Kunststoff hergestellt ist.

Dadurch wird vermieden, daß nennenswerte Energiemengen der Laserimpulse vom Folienmaterial selbst absorbiert werden und zu einer unerwünschten Aufheizung der Folie im Bereich des Auftreffpunktes der Laserstrahlung führen.

Vielmehr ermöglicht dieses Merkmal der Erfindung, daß der jeweilige Laserstrahl gegebenenfalls auch von der Rückseite der Folie her durch diese hindurch auf die Metallschicht auftrifft und dort eine metallfreie Fläche bildet, ohne daß eine Verformung oder Beschädigung der thermoplastischen Folie auftrifft.

Bei Verwendung eines Neodym-YAG-Lasers (YAG = Yttrium-Aluminium-Granat) mit einer Wellenlänge von 1,06 µm kann beispielsweise vorteilhaft Polyäthylenterephthalat als Folienmaterial eingesetzt werden, da eine 3 µm starke Folie aus diesem Material nur wenige Prozent der auftreffenden Laserintensität absorbiert.

Selbstverständlich bietet es sich zur Bildung mehrerer metallfreier Streifen in der Metallschicht einer Kunststoffolie an, ähnlich wie im Verfahren der bereits genannten US-PS 4 462 062 mehrere Sätze von jeweils n Laserstrahlen nebeneinander nach dem Verfahren der Erfindung auf die verschiedenen zu entmetallisierenden Bereiche der Folienoberfläche zu richten und mit jedem Satz von n Laserstrahlen einen einzelnen metallfreien Streifen zu bilden.

Die Erfindung wird im folgenden anhand der Figuren dem Stand der Technik gegenübergestellt und näher erläutert. Im einzelnen zeigen

Fig. 1 drei mögliche Arten der Bildung von metallfreien Streifen durch überlappende Aneinanderreihung von entmetallisierten Flächen,

Fig. 2 die Bildung eines metallfreien Streifens mittels eines einzigen Laserstrahls,

Fig. 3 die Bildung eines metallfreien Streifens gemäß der Erfindung unter Verwendung von n = 3 Laserstrahlen,

Fig. 4 die vorteilhafte Führung der Folie zwischen benachbarten Laserstrahlen über eine Anordnung von drei Umlenkrollen.

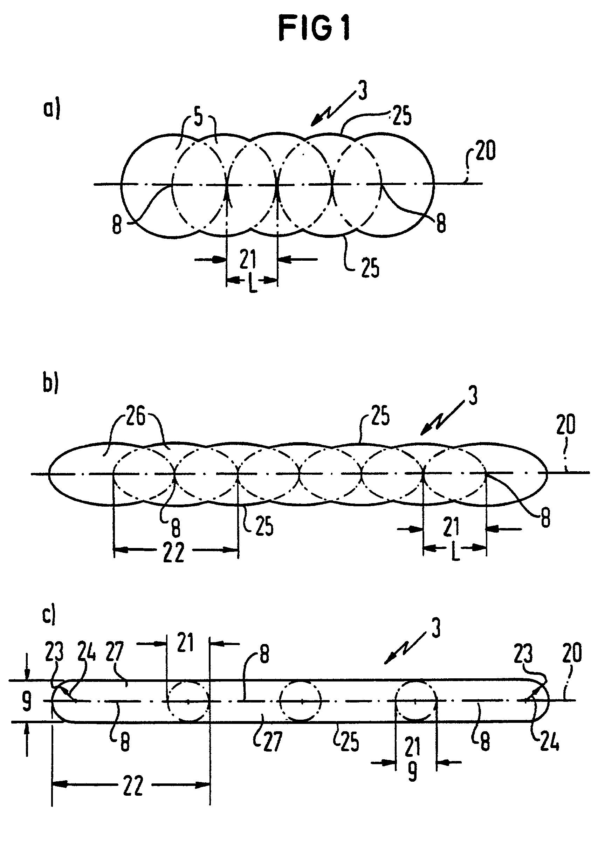

Fig. 1 zeigt schematisch Beispiele zur Bildung von vollständig metallfreien Streifen in der Metallschicht einer metallisierten Kunststoffolie durch sukzessive Aneinanderreihung von sich teilweise überlappenden, entmetallisierten Flächen, die jeweils um eine bestimmte Strecke versetzt sind.

Die Flächen entstehen durch einen kurzen, intensiven Impuls eines Laserstrahles, durch den das Metall im Bereich des Auftreffpunktes der Laserstrahlung auf der Folienoberfläche schlagartig verdampft wird. Die Form dieser Flächen ist durch entsprechende Kombination von Linsen und Blenden veränderbar.

Fig. 1 a) zeigt einen Streifen 3, der durch Aneinanderreihung von kreisförmigen Flächen 5 gebildet wird, die sich auf der Verbindungslinie 20 ihrer Zentren 8 um eine Strecke 21 überlappen, die ihrem Radius L entspricht. Dieser Streifen weist einen typischen, wellenförmigen Randbereich 25 auf. In der bevorzugten Ausführung haben diese Flächen einen Radius von 0,1 mm. Es können nen jedoch auch kleinere oder größere Flächen gebildet werden.

Die Aneinanderreihung von elliptisch geformten Flächen 26, die sich um die Strecke 21 einer großen Halbachse L auf der Verbindungslinie 20 ihrer Zentren 8 überlappen, zeigt die Figur 1 b). Auch hier ist der Randbereich 25 gewellt.

Schließlich ist in Fig. 1 c) die vorteilhafte Bildung von metallfreien Streifen 3 durch Aneinanderreihung von Flächen 27 gezeigt, deren Form dem Querschnitt eines Langloches entspricht. Diese Flächen 27 mit einer Breite 9, die deutlich kleiner als ihre Länge 22 ist, besitzen runde Enden 23 mit einem Radius 24, der genau der Hälfte ihrer Breite 9 entspricht.

Wie bereits erwähnt, genügt es, wenn sich diese Flächen 27 auf der Verbindungslinie 20 ihrer Zentren 8 um eine Strecke 21 überlappen, die gerade der Breite 9 dieser Flächen 27 entspricht, um einen zusammenhängend entmetallisierten Streifen 3 zu bilden, dessen Randbereich 25 praktisch keine wellenförmige, sondern eine glatte Berandung aufweist.

Die bevorzugte Ausführungsform dieser Flächen weist eine Länge 22 von 0,5 mm und eine Breite 9 von 0,2 mm auf.

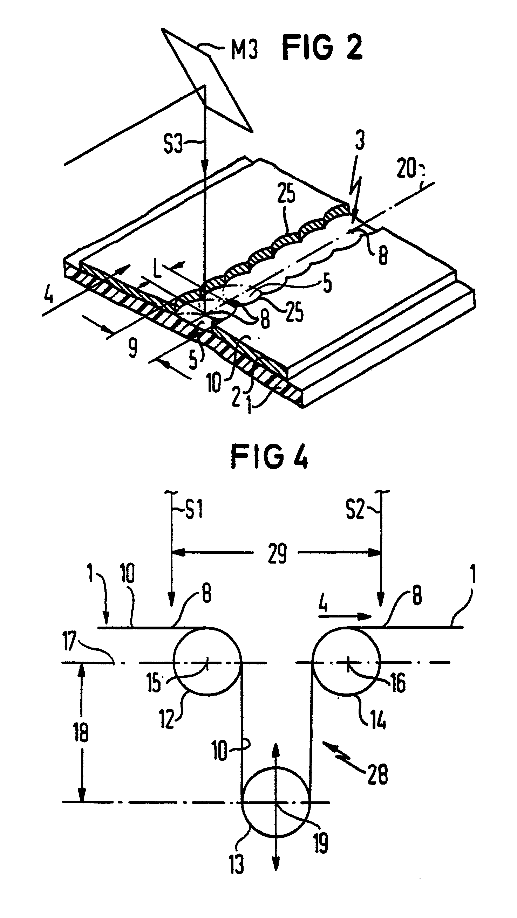

Fig. 2 zeigt stark schematisch die Bildung eines vollständig entmetallisierten Streifens 3 in der Metallschicht 2 einer Kunststoffolie 1 durch Aneinanderreihung sich teilweise überlappender, annähernd kreisförmiger, metallfreier Flächen 5, die durch jeweils einen intensiven Laserimpuls eines Laserstrahls S1 auf der Folienoberfläche 10 erzeugt werden, durch den das Material der Metallisierung im Bereich des Auftreffpunktes der Laserstrahlung schlagartig verdampft wird. Der Laserstrahl S1 wird dabei durch einen Spiegel M1 senkrecht auf die Folienoberfläche 10 abgelenkt.

Die Kunststoffolie wird mit einer Vorschubgeschwindigkeit v in Bandlaufrichtung 4 relativ zum Laserstrahl S1 bewegt, die so mit der Taktfrequenz f des Lasers synchronisiert ist, daß die Überlappungsstrecke, auf der sich die nacheinander entmetallisierten Flächen 5 entlang der Verbindungslinie 20 ihrer Zentren (8) überdecken, gerade dem Radius L dieser Flächen 5 entspricht, was einen vernünftigen Kompromiß zwischen möglichst hoher Entmetallisierungsgeschwindigkeit und möglichst glattem Randbereich 25 der gebildeten Streifen 3 darstellt.

Kennzeichnend für dieses Verfahren, das dem Stand der Technik entspricht, ist, daß jeder Laserimpuls teilweise auf ein bereits entmetallisiertes und damit thermisch beanspruchtes Gebiet der Folienoberfläche 10 auftrifft, was bei unzureichender Abkühlzeit zu Verformung und Beschädigung des thermoplastischen Materials, insbesondere bei sehr dünnen Folien, führen kann und einen Nachteil des Verfahrens darstellt.

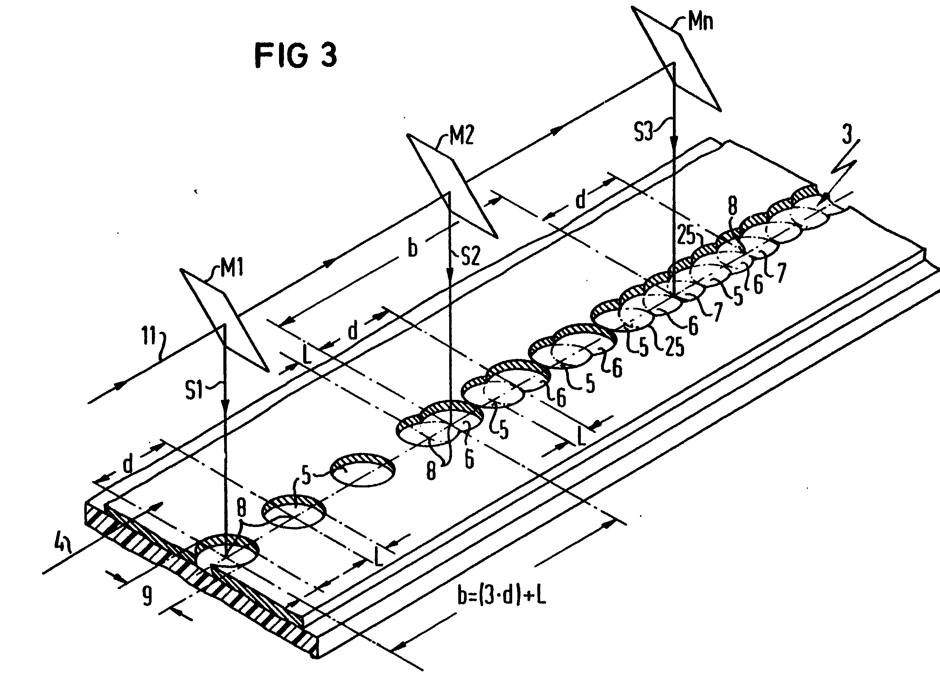

Fig. 3 zeigt schematisch das Verfahren der Erfindung für eine Anzahl von n = 3 Laserstrahlen, die vorteilhaft durch Verwendung von zwei teildurchlässigen Spiegeln M1, M2 aus einem einzelnen Laserstrahl 11 erzeugt werden, wodurch aufwendige Synchronisationsmaßnahmen für die drei gepulsten Laserstrahlen wegfallen.

Das Verfahren der Erfindung wird bevorzugt bei Folien aus Polyäthylenterephthalat mit einer Dicke von 2 μm angewendet, die eine 30 nm dicke Metallschicht 2 aus Aluminium besitzen.

Die Laserstrahlen S1, S2 und S3 werden dabei durch die beiden teildurchlässigen Spiegel M1, M2 und durch den total reflektierenden Spiegel $M_n$ unter einem 90° Winkel so abgelenkt und auf die metallisierte Folienoberfläche 10 gerichtet, daß sie in einer Ebene parallel zueinander angeordnet sind und im Bereich eines zu entmetallisierenden Streifens 3 lotrecht auf die Folienoberfläche 10 auftreffen.

Als Laser findet ein Neodym-YAG-Laser Verwendung, dessen Strahlleistung ausreichend hoch ist, um bei einer bevorzugten Impulsdauer von 250 ns bei jedem Laserimpuls der 3 Laserstrahlen S1 bis S3 metallfreie Flächen 5, 6, 7 in der Metallschicht 2 der Folie 1 zu erzeugen, wobei jeder Laserstrahl S1 bis S3 in der bevorzugten Ausführung des Verfahrens über eine Strahlleistung von 2W bis 5W, vorzugsweise 3,75 Watt verfügt.

In dem dargestellten Ausführungsbeispiel besitzen die von jedem Laserimpuls entmetallisierten Flächen (5, 6, 7) die einfache Form eines Kreises mit einem Radius L von 0,1 mm.

Die Taktfrequenz f des Lasers beträgt bevorzugt 10 kHz, kann jedoch beliebig verringert und an die Notwendigkeiten des Verfahrens angepaßt werden.

Erfindungsgemäß sind Bandvorschubgeschwindigkeit v und Lasertaktfrequenz f so aufeinander abgestimmt, daß der Taktabstand d der Zentren 8 zweier nacheinander von demselben Laserstrahl entmetallisierter Flächen das Dreifache des Flächenradius L beträgt, was gegenüber einem Verfahren mit nur einem Laserstrahl bei gleicher Taktfrequenz f eine um den Faktor 3 höhere Vorschubgeschwindigkeit v ermöglicht.

Bei einem resultierenden Taktabstand d von 3 x L = 0,3 mm beträgt die bei einer Taktfrequenz f von 10 kHz erzielbare Entmetallisierungsgeschwindigkeit bereits 3 m/s. Werden anstelle der aus Gründen der Übersichtlichkeit dargestellten kreisförmigen Flächen mit einem Radius L von 0,1 mm die in Fig. 1 c) näher beschriebenen Flächen 27 in Langlochform mit der bevorzugten Länge 22 von 0,5 mm bei einem Taktabstand d von 3 x 0,3 mm zur Bildung der metallfreien Streifen verwendet, so erhöht sich bei gleichbleibender Taktfrequenz von 10 kHz die resultierende Entmetallisierungsgeschwindigkeit bereits auf 9 m/s oder 32,4 km/h. Dieser Wert kann durch Erhöhung der Anzahl n der eingesetzten Laserstrahlen noch weiter erhöht werden.

Die Abkühlstrecke b hat erfindungsgemäß um den n-ten Teil des Taktabstandes d, also gerade um den Radius L der entmetallisierten Flächen 5, 6, 7 größer zu sein, als ein ganzzahliges Vielfaches des Taktabstandes d. In der schematischen Darstellung des Verfahrens in Fig. 2 beträgt dieser Abstand 3 x d (+ L) = (3 x 3 L) + L = 10 L.

Die daraus resultierende Abkühlphase bis zum Auftreffen eines Laserimpulses auf eine bereits entmetallisierte Fläche der Folie 1 erstreckt sich somit jeweils über 3 Takte des gepulsten Lasers, was bedeutet, daß die Abkühlphase um den Faktor 3 länger ist, als bei einem Verfahren mit nur einem Laserstrahl.

In der Praxis wird man die Abkühlstrecke b, die im Beispiel der Fig. 3 zur übersichtlicheren Darstellung des Verfahrens nur 10 x L oder 1 cm beträgt, sicher wesentlich größer wählen, so daß sich die Abkühlphase beispielsweise über 20 Takte oder mehr des Lasers erstreckt, was einer Abkühlstrecke von 6,1 cm oder mehr entspricht.

Nach dem dritten Laserstrahl S3 liegt ein vollständig entmetallisierter, aus sich überlappenden, kreisförmigen Flächen 5, 6, 7 aufgebauter Streifen 3 vor, der der bei gleicher Taktfrequenz f in einem Drittel der Zeit gebildet wurde, die mit einem einzigen Laserstrahl zu seiner Bildung erforderlich ist und der wegen der dreifach längeren Abkühlphase gegenüber den üblichen Verfahren mit einem Laserstrahl ohne Gefahr einer thermoplastischen Verformung der Folie hergestellt wurde.

Fig. 4 beschreibt, wie die zu entmetallisierende Folie 1 vorteilhaft zwischen zwei benachbarten Laserstrahlen S1, S2 über je einer Anordnung 28 von drei Umlenkrollen 12, 13, 14 aus Metall oder einem anderen, gut wärmeleitenden Material geführt wird. Der Abstand 29 zwischen den benachbarten Laserstrahlen S1, S2 kann somit deutlich kleiner sein, als die erforderliche Abkühlstrecke b zwischen den Zentren 8 zweier von benachbarten Laserstrahlen S1, S2 zur selben Zeit auf der Folienoberfläche 10 entmetallisierter Flächen. Die drei Umlenkrollen 12, 13, 14 sind im Beispiel der Figur 4 so angeordnet, daß die Achsen 15, 16 der ersten und der dritten Umlenkrolle 12, 14 in einer Ebene 17 liegen, die zweite Umlenkrolle 13 außerhalb dieser Ebene 17 liegt und daß der Abstand 18 der Achse 19 der zweiten Umlenkrolle 13 von der Ebene 17 verstellbar ist.

Bezugszeichenliste

1 Kunststoffolie
2 Metallschicht
3 entmetallisierter Streifen
4 Richtung des Folienvorschubs
5,6,7 entmetallisierte, kreisförmige Flächen
8 Zentren der Flächen 5, 6, 7, 26, 27
9 Flächenbreite und Breite des entmetallisierten Streifens 3
10 Folienoberfläche
11 Hauptlaserstrahl
12 erste Umlenkrolle
13 zweite Umlenkrolle
14 dritte Umlenkrolle
15 Achse von 12
16 Achse von 14
17 Ebene der Achsen 15 und 16
18 Abstand der Achse 19 von der Ebene 17
19 Achse von 13
20 Verbindungslinie der Zentren 8
21 Überlappungsstrecke der Flächen 5, 6, 7, 26, 27 entlang der Linie 20
22 Länge der Flächen 5, 6, 7, 26, 27
23 Enden der Flächen 27 mit Langlochform
24 Radius der Enden 23
25 Randbereich des entmetallisierten Streifens 3
26 entmetallisierte, elliptische Flächen
27 entmetallisierte Flächen mit Langlochform
28 Anordnung von drei Umlenkrollen 12, 13, 14
29 Abstand benachbarter Laserstrahlen
n Anzahl der Laserstrahlen
S1 bis Sn Laserstrahlen
M1 bis Mn-1 teildurchlässige Spiegel
Mn totalreflektierender Spiegel
L halbe Länge der entmetallisierten Flächen 5, 6, 7, 26, 27
d Taktabstand
b Abkühlstrecke

## Patentansprüche

1. Verfahren zur Bildung von metallfreien Streifen auf einer Kunststoffolie, die mit einer dünnen, insbesondere regenerierfähig dünnen Schicht eines verdampfbaren Metalls, insbesondere Aluminium, versehen ist und zur Herstellung von elektrischen Kondensatoren dient, bei dem die Metallschicht an den zu entmetallisierenden Bereichen durch intensive, gepulste Laserstrahlen von der Oberfläche der relativ zu den Laserstrahlen bewegten Kunststoffolie entfernt wird, gekennzeichnet durch die Verfahrensschritte

a) die metallisierte Kunststoffolie (1) wird mit einer Vorschubgeschwindigkeit v relativ zu einer Anzahl n > 1 mit der Taktfrequenz f gepulster Laserstrahlen (S1 - Sn) bewegt, die die Metallschicht (2) der Kunststoffolie (1) in dem Bereich eines zu entmetallisierenden Streifens (3) beaufschlagen und die parallel zueinander in einer Ebene angeordnet sind, zu der die Richtung (4) der Translationsbewegung der Kunststoffolie (1) parallel verläuft,

b) durch Dauer und Intensität der einzelnen Impulse der Laserstrahlen S1 bis Sn wird bei jedem Impuls nur eine Fläche (5, 6, 7, 26, 27) der Metallschicht (2) verdampft,

c) der aus Vorschubgeschwindigkeit v der Folie und Taktfrequenz f der Laserimpulse resultierende Taktabstand (d) der Zentren (8) zweier nacheinander von demselben Laserstrahl entmetallisierter Flächen beträgt mindestens ein der Anzahl n der verwendeten Laserstrahlen entsprechendes Vielfaches der halben Länge (L) dieser Flächen, höchstens aber das n-fache der um die Hälfte der Flächenbreite (9) verkürzten Länge der entmetallisierten Flächen (5, 6, 7, 26, 27),

d) der Abstand der Zentren (8) der Bereiche, in denen zwei benachbarte Laserstrahlen auf die Oberfläche (10) der metallisierten Kunststoffolie (1) auftreffen, nämlich die Abkühlstrecke (b), ist jeweils um den n-ten Teil des Taktabstandes (d) größer als ein ganzzahliges Vielfaches des Taktabstandes (d) der Zentren (8) zweier benachbarter, von demselben Laserstrahl entmetallisierter Flächen.

2. Verfahren nach Anspruch 1, **dadurch gekennzeichnet**, daß die in einer Ebene parallel zueinander angeordneten n Laserstrahlen unter Verwendung n - 1 teildurchlässiger Spiegel (M1 bis Mn-1) und eines total reflektierenden Spiegels (Mn) aus einem einzelnen Laserstrahl (11) erzeugt werden und durch die Wahl des Reflexionsvermögens der einzelnen teildurchlässigen Spiegel der ursprüngliche Laserstrahl (11) in n Strahlen annähernd gleicher Energie aufgeteilt wird.

3. Verfahren nach Anspruch 1 oder 2, **dadurch gekennzeichnet**, daß die metallisierte Kunststoffolie (1) zwischen zwei benachbarten Laserstrahlen (S1,S2), über wenigstens eine Anordnung von 3 Umlenkrollen (12, 13, 14 ) geführt wird, von denen die erste und die dritte Umlenkrolle (12, 14) hinsichtlich ihrer Achsen (15, 16) in einer Ebene (17) liegen und die zweite Umlenkrolle (13) zwischen der ersten und dritten Umlenkrolle (12, 14) außerhalb der Ebene (17) ihrer Achsen (15, 16) angeordnet ist, daß die Umlenkrollen (12, 13, 14) aus Metall oder einem anderen gut wärmeleitendem Metall bestehen und daß der Abstand (18) der Achse (19) der zweiten Umlenkrolle (13) von der Ebene (17), in der die Achsen (15, 16) der beiden äußeren Umlenkrollen (12, 14) liegen, zum Einstellen der erforderlichen Abkühlstrecke (b) verstellbar ist.

4. Verfahren nach Anspruch 1, 2 oder 3, **dadurch gekennzeichnet**, daß die n Laserstrahlen (S1 bis Sn) lotrecht auf die Oberfläche (10) der metallisierten Kunststoffolie (1) auftreffen.

5. Verfahren nach einem der Ansprüche 1 bis 4, **dadurch gekennzeichnet**, daß zur Bildung von metallfreien Flächen (26, 27) in Form von Ellipsen oder Langlöchern, deren Längsausdehnung 22 mit der Richtung (4) der Translationsbewegung der Kunststoffolie (1) übereinstimmt, in den Strahlengang jedes Laserstrahles (S1 bis Sn) jeweils wenigstens eine den Strahlenquerschnitt der Laserstrahlen (S1 bis Sn) beeinflussende Optik eingebracht wird.

6. Verfahren nach einem der Ansprüche 1 bis 5, **dadurch gekennzeichnet**, daß die metallisierte Folie (1) aus einem für die Strahlung des Lasers weitgehend transparenten Kunststoff hergestellt ist.

**Claims**

1. Process for producing metal-free strips on a plastic foil, which is provided with a thin, especially regenereably thin coating of a vaporizable metal especially aluminium, and serves the production of electrical capacitors, in which the metal coating at the zones to be demetallized is removed by intense, pulsed laser beams from the surface of the plastic foil moved relative to the laser beams, characterized by the process steps

a) the metallized plastic foil (1) is moved at a feedrate v relative to a number n >> 1 with the pulse frequency f of pulsed laser beams (S1–Sn), which are applied to the metal coating (2) of the plastic foil (1) in the zone of a strip (3) to be demetallized and are arranged parallel to one another in a plane, to which runs parallel the direction (4) of the translational movement of the plastic foil (1),

b) by means of the duration and intensity of the individual pulses of the laser beams S1 to Sn, only one area (5, 6, 7, 26, 27) of the metal coating (2) is vapourised with each pulse,

c) the pulsed separation (d) of the centres (8) of two areas sequentially demetallized by the same laser beam, which pulsed separation (d) results from the feedrate v of the foil and the pulse frequency f of the laser pulses, amounts to at least a multiple of the half length (L) of these areas which corresponds to the number n of the laser beams employed, but at most to n times the length of the demetallized areas (5, 6, 7, 26, 27) shortened by the half of the area width (9),

d) the separation of the centres (8) of the zones in which two adjacent laser beams strike the surface (10) of the metallized plastic foil (1), namely the cooling distance (b), is respectively greater by the n-th part of the pulsed separation (d) than an integral multiple of the pulsed separation (d) of the centres (8) of two adjacent areas demetallized by the same laser beam.

2. Process according to Claim 1, characterized in that the n laser beams arranged parallel to one another in a plane are produced from a single laser beam (11) by the use of n–1 partially transparent mirrors (M1 to Mn–1) and a totally reflecting mirror (Mn), and the original laser beam (11) is split into n beams of approximately equal energy by selecting the reflectivity of the individual partially transparent mirrors.

3. Process according to Claim 1 or 2, characterized in that the metallized plastic foil (1) between two adjacent laser beams (S1, S2) is guided over at least one arrangement of 3 guide rollers (12, 13, 14), of which the first and the third guide roller (12, 14) lie in a plane (17) with respect to their axes (15, 16), and the second guide roller (13) is arranged between the first and third guide roller (12, 14) outside the plane (17) of their axes (15, 16), in that the guide rollers (12, 13, 14) consist of metal or of another metal which conducts heat well, and in that the separation (18) of the axis (19) of the second guide roller (13) from the plane (17) in which the axes (15, 16) of the two outer guide rollers (12, 14) lie can be adjusted in order to set the required cooling distance (b).

4. Process according to Claim 1, 2 or 3, characterized in that the n laser beams (S1 to Sn) strike perpendicular to the surface (10) of the metallized plastic foil (1).

5. Process according to one of claims 1 to 4, characterized in that in order to produce metal-free areas (26, 27) in the shape of ellipses or oblong holes, the longitudinal extent (22) of which corresponds to the direction (4) of the translational movement of the plastic foil (1), at least one optical system influencing the beam cross-section of the laser beams (S1 to Sn) is introduced in each case into the beam path of each laser beam (S1 to Sn).

6. Process according to one of claims 1 to 5, characterized in that the metallized foil (1) is produced from a plastic which is largely transparent to the radiation of the laser.

## Revendications

1. Procédé pour former des bandes exemptes de métal sur une feuille en matière plastique, qui est pourvue d'une couche mince, notamment régénérable, d'un métal pouvant être évaporé, notamment de l'aluminium, et est utilisée pour fabriquer des condensateurs électriques, et selon lequel on élimine au niveau des zones devant être démétallisées, à l'aide de faisceaux laser intenses pulsés, la couche métallique, de la surface de la feuille de matière plastique déplacée par rapport aux faisceaux laser, caractérisé par les étapes opératoires

a) on déplace la feuille de matière plastique métallisée (1) avec une vitesse d'avance v par rapport à un certain nombre n >> 1 de faisceaux laser (S1–Sn), qui sont pulsés à la fréquence f, frappent la couche métallique (2) de la feuille de matière plastique (1) dans la zone d'une bande (3) devant être démétallisée et sont disposés parallèlement les uns aux autres dans un plan, auquel est parallèle la direction (4) du mouvement en translation de la feuille de matière plastique (1),

b) lors de chaque impulsion, on réalise l'évaporation uniquement d'une surface (5, 6, 7, 26, 27) de la couche métallique (2), grâce à un réglage de la durée et de l'intensité des différentes impulsions des faisceaux laser (S1 à Sn),

c) la distance de décalage (d), qui résulte de la vitesse v de la feuille et de la fréquence s des impulsions laser, entre les centres (8) de deux feuilles démétallisées successivement par le même faisceau laser est égale au moins à un multiple, qui correspond au nombre n des faisceaux laser utilisés, de la moitié (L) de la longueur de cette surface, mais est égale ou plus à n fois la longueur des surfaces démétallisées (5, 6, 7, 26, 27), diminuée de la moitié de la largeur (9) des surfaces,

d) la distance entre les centres (8) des zones, dans lesquelles deux faisceaux laser voisins tombent sur la surface (10) d'une feuille en matière plastique métallisée (1), à savoir la distance de refroidissement (b), est respectivement supérieure, de la n-ème partie de la distance de décalage (d), à un multiple entier de la distance d'avance (d) entre les centres (8) de deux surfaces voisines, démétallisées au moyen du même faisceau laser.

2. Procédé suivant la revendication 1, caractérisé par le fait que les n faisceaux laser disposés parallèlement les uns aux autres dans un plan, sont produits moyennant l'utilisation de n−1 miroirs partiellement transparents (M1 à Mn−1) et d'un miroir à réflexion totale (Mn), à partir d'un faisceau laser unique (11), et que le faisceau laser d'origine (11) est subdivisé en n faisceaux fournissant une énergie approximativement identique, grâce au choix du pouvoir réfléchissant des différents miroirs partiellement réfléchissants.

3. Procédé suivant la revendication 1 ou 2, caractérisé par le fait que la feuille en matière plastique métallisée (1) circule entre deux faisceaux laser voisins (S1, S2), sur au moins un dispositif formé de 3 rouleaux de renvoi (12, 13, 14), les axes (15, 16) des premier et troisième rouleaux de renvoi (12, 14) étant situés dans un plan (17), tandis que le second rouleau de renvoi (13) est disposé entre les premier et troisième rouleaux de renvoi (12, 14), à l'extérieur du plan (17) formé par les axes (15, 16) de ces rouleaux, que les rouleaux de renvoi (12, 13, 14) sont réalisés en un métal ou en un autre matériau bon conducteur de la chaleur, et que la distance (18) entre l'axe (19) du second rouleau de renvoi (13) et la plan (17), dans lequel sont situés les axes (15, 16) des deux rouleaux de renvoi extérieurs (12, 14), est réglable de manière à permettre le réglage de la distance nécessaire de refroidissement (b).

4. Procédé suivant la revendication 1, 2 ou 3, caractérisé par le fait que les n faisceaux laser (S1 à Sn) tombent perpendiculairement sur la surface (10) de la feuille de matière plastique métallisée (1).

5. Procédé suivant l'une des revendications 1 à 4, caractérisé par le fait que pour la formation de surfaces (26, 27) exemptes de métal, sous la forme d'ellipses ou de trous allongés, dont l'extension longitudinale (22) est orientée dans la direction (4) du mouvement de translation de la feuille de matière plastique (1), et que respectivement au moins un système optique influençant la section transversale du rayonnement des faisceaux laser (S1 à Sn) est inséré dans le trajet de rayonnement de chaque faisceau laser (S1 à Sn).

6. Procédé suivant l'une des revendications 1 à 5, caractérisé par le fait que la feuille métallisée (1) est réalisée en une matière plastique dans une large mesure transparente pour le rayonnement du laser.

# FIG 1

## M3 FIG 2

## FIG 4

# FIG 3

b=(3·d)+L

EP 0 200 089 B1